# EUROPEAN PATENT SPECIFICATION

(11) **EP 1 732 218 B1**
(45) Date of publication and mention of the grant of the patent: **10.12.2008**
(21) Application number: 05105083.9
(22) Date of filing: 09.06.2005
(51) Int. Cl.: H03H 9/215, G04C 3/12

(54) **Small-sized piezoelectric resonator**
Piezoelektrischer Resonator mit kleinen Abmessungen
Résonateur piézoélectrique à dimensions réduites

(43) Date of publication of application: 13.12.2006
(73) Proprietor: ETA SA Manufacture Horlogère Suisse, 2540 Grenchen (CH)
(72) Inventor: Dalla Piazza, Silvio, 2610 Saint-Imier (CH); Studer, Bruno, 4533 Riedholz (CH); Lüthi, Thomas, 2540 Grenchen (CH)
(74) Representative: Vigand, Philippe

(56) References cited:
- GB-A- 1 255 765
- US-A- 3 462 939
- US-A1- 2003 067 248
- US-A1- 2005 062 368

## Description

### FIELD OF INVENTION

The present invention concerns piezoelectric resonators and more particularly resonators of small dimensions which are most often used for making frequency generators in particular for portable electronic equipment, in numerous fields such as horology, information technology, telecommunications and the medical field.

### BACKGROUND OF THE INVENTION

Such a resonator of small dimensions has been disclosed in the prior art document US 6,700,313 filed in the name of the name Assignee. Resonator 10 represented on Figure 13, which is intended to be mounted in a case, includes a tuning fork shaped part with two parallel arms 12, 14 connected to each other by a linking part 16 and carrying electrodes 20, 22 to make them vibrate, these electrodes being connected to connecting pads 28, 30 intended to be electrically connected to the exterior of the case. Resonator 10 also includes a central arm 18 attached to linking part 16 and located between arms 12, 14 of the tuning fork shaped part, substantially equidistant from them, this central arm 18 having a greater mass than that of the arms of the tuning fork shaped part and connected pads 28, 30 are carried by this central arm. This resonator is mounted in a case of parallelepiped shape by fixing its central arm 18 to at least one support secured to the bottom of the case.

The above described kind of resonators, called hereinafter three arm resonators, allows breaking away from many problems encountered with conventional tuning fork resonators.

One of these problems is that the dimensional and functional features of the conventional tuning fork resonators are optimised for mounting them in metallic cases and not in ceramic cases. For example, the ratio between their length and their width is ill suited to the manufacture of such cases, in particular when the cases are of the SMD (Surface Mounting Device) type, i.e. meant to be automatically mounted on hole-free printed circuit boards. Because of this, a conventional tuning fork resonator and its connection to the case do not have very good resistance to shocks.

Further conventional tuning fork resonators are liable to tip towards the bottom of the case when it is fixed onto a step of the case.

Furthermore, since the thermal expansion coefficients of ceramic material and quartz are different enough to create mechanical stresses in the resonator which can not only be felt in the arms of the tuning fork and disturb the working of the resonator when the temperature changes but can also break the solder or detach connection pads of the resonator from those of the case and alter or even cut the electric connection between the resonator electrodes and the external contact pads of the case.

For the same reason, if there is an incipient fracture on the side of base of the tuning fork where connection pads are situated, a significant temperature variation can even break the tuning fork.

Finally, when the resonator is vacuum packed, the vacuum is never perfect and the stirring of the atmosphere by the tuning fork arms when the resonator vibrates can modify the operating parameters of the resonator when its arms come close to each other, more so than in the case of a metallic case.

Thus, three arm resonators enable satisfactory solutions to be brought to the various problems posed by conventional tuning fork resonators. Nevertheless although these three arm resonators have proved to be advantageous, miniaturization requirements of the resonator and consequently of its packaging are critical issues for mobile phones or wristwatch applications which implies a permanent concern of the one skilled in the art for accurately mounting the resonator inside its packaging in order to prevent any shock between both when the resonator vibrates.

### SUMMARY OF THE INVENTION

The main goal of the present invention is to provide a three arm resonator which enables to mount it accurately inside its packaging and therefore prevents mechanical shocks between the resonator and its packaging when the resonator vibrates.

For that purpose according to a first object of the invention, it concerns a piezoelectric resonator to be mounted in a case and including a tuning fork shaped with two parallel vibrating arms connected to each other by a linking part, from which protrude a central arm located between both vibrating arms. The vibrating arms carry electrodes to make them vibrate, these electrodes being connected to connection elements carried by the central arm. The connection elements are electrically connected and fixed to the case, wherein at least one connection element comprises an opening through the central arm for accurately positioning the resonator into the case. Such resonator guarantees an accurate positioning of the resonator inside its packaging by the means of the opening cut through the central arm which allows seeing marks in the case visible through the opening.

According to another aspect of the invention, in order to reduce consumption of energy by producing an excitation electrical field which is more homogeneous and locally more intense and for which vibration loss at the arms is low even when the size of the vibrating piece is miniaturized and the CI value (crystal impedance or equivalent series resistance) can also be suppressed at a low level, the resonator is provided with at least one groove formed on at least one of a front side and a rear side of each vibrating arm. Use of grooves on the vibrating arms furnishes precise performances even when the device is miniaturized.

According to another aspect of the invention, in order to increase the vibrating coupling effect of the vibrating arms, the grooves extend in the linking part. Grooves extending in the linking part where mechanical stresses are maximum, allow retrieving the electrical field in this high stressed area.

According to another aspect of the invention, in order to further optimize homogeneity of the excitation electrical field, two grooves are provided on each front and rear sides of each vibrating arms.

According to another aspect of the invention, in order to guarantee a sufficient mechanical resistance in the high stressed area, interior grooves which are located on the inside with respect to the central arm extend shorter within the linking part than the exterior grooves which are located on the outside with respect to the central arm.

According to another aspect of the invention, in order to further reduce dimensions of such a three arm resonator, in particular its length, while keeping above listed advantages, the width of said central arm is greater or equal to one and a half the width of the vibrating arms and the free end of the central arm does not extend beyond the vibrating arms.

According to another aspect of the invention, in order to further reduce the dimensions of such a three arm resonator, in particular its length, the length of the central arm is less than that of the vibrating arms and the vibrating arms end in flippers extending beyond said central arm, the flipper width being larger than that of the vibrating arms.

According to another aspect of the invention, in order to further stabilize the resonator when vibrating, a balancing reed attached to the central arm extends between both flippers, width of this balancing reed being smaller than that of the central arm.

According to another aspect of the invention, in order to avoid mechanical stress on the fixing part of the resonator due to vibrations of the arms, either a decoupling hole or decoupling notches or both are arranged through, respectively on the central arm.

According to another aspect of the invention, in order to further reduce the length of the resonator and decouple the central arm from the vibrating arms, a notch is arranged on the side of the linking part opposite to that of the central arm.

According to a second object of the invention, it concerns a piezoelectric resonator to be mounted in a case and including a tuning fork shaped with two parallel vibrating arms connected to each other by a linking part, from which protrude a central arm located between both vibrating arms. The width of the central arm is about the same as that of the vibrating arms. The vibrating arms carry electrodes to make them vibrate. A base part protrudes from the central arm opposite to the linking part. The electrodes are connected to connection elements carried by the base part, electrically connected and fixed to the case, wherein at least one connection element comprises an opening through the base part for positioning said resonator into the case. Such a resonator guarantees an accurate positioning of the resonator inside its packaging by the means of the opening through the base part which allows marks of the packaging to be visible. It also allows reducing the dimensions of the resonator, in particular its width.

### BRIEF DESCRIPTION OF THE DRAWINGS

Other features and advantages of the invention will appear upon reading the following description which refers to the annexed drawings in which:
- Figures 1a, 1b and 1c are respectively bottom, top and cut views of a first embodiment of a piezoelectric resonator according to the invention;
- Figure 2 is a bottom view of a second embodiment of a piezoelectric resonator according to the invention;
- Figure 3 is a bottom view of a third embodiment of a piezoelectric resonator according to the invention;
- Figure 4 is a bottom view of a fourth embodiment of a piezoelectric resonator according to the invention;
- Figures 5a, 5b, 5c and 5d are bottoms views of four variants of the first embodiment of the piezoelectric resonator according to the invention;
- Figure 6 is a bottom view of a variant of the second embodiment of the piezoelectric resonator according to the invention;
- Figures 7a and 7b are bottom views of two variants of the third, respectively fourth embodiment of the piezoelectric according to the invention;
- Figure 8 is a bottom view of still another variant of the first embodiment of the piezoelectric resonator according to the invention;
- Figures 9a and 9b are still other variants of the first embodiment of the piezoelectric resonator according to the invention;
- Figures 10a and 10b are top views of a suitable package for receiving a piezoelectric resonator according to the invention;
- Figures 11a and 11b are top views of a piezoelectric resonator mounted in a suitable package according respectively to the first and second embodiments;
- Figures 12a and 12b are top views of a piezoelectric resonator mounted in a suitable package according respectively to the third and fourth embodiment;

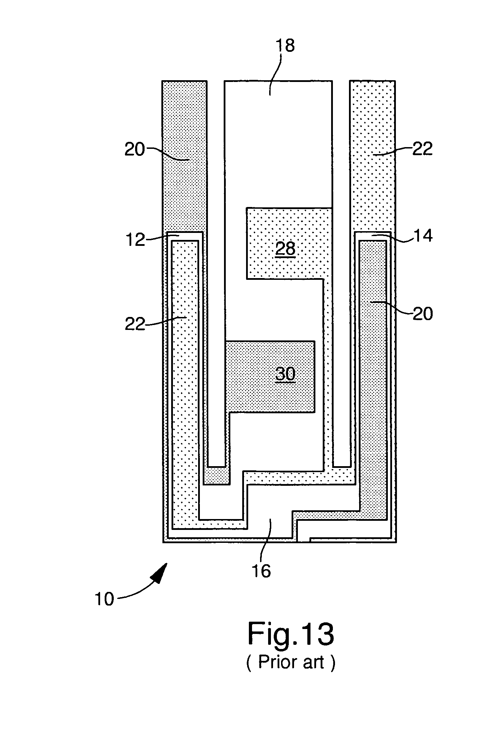

- Figure 13, already described, is a top view of a piezoelectric resonator according to the prior art.

### DETAILED DESCRIPTION OF THE INVENTION

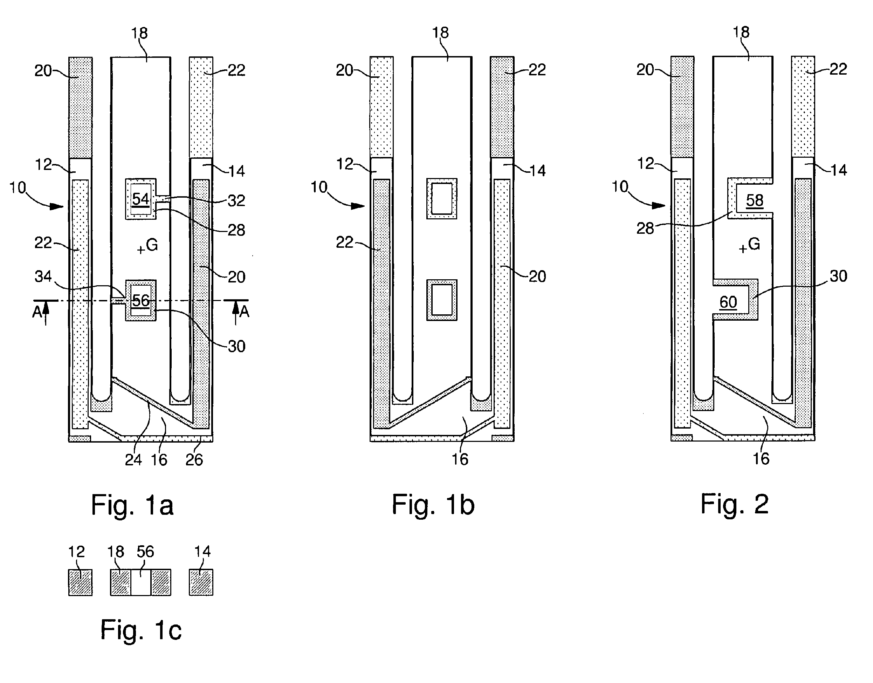

In the first embodiment shown in relation with Figures 1a, 1b and 1c, the resonator according to the invention, designated by the reference numeral 10, to be mounted in a case not shown, includes a tuning fork shaped part with two vibrating arms 12 and 14 joined by a linking part 16 to which a central arm 18, located between arms 12 and 14 and parallel thereto, is attached, the whole assembly being made in a single piece and of quartz.

As shown by Figures 1 a and 1 b, vibrating arms 12 and 14 carry two groups of electrodes 20 and 22, which are connected to each other by conductive paths respectively 24 and 26, carried by linking part 16 of the tuning fork shaped part. As they are shown in the drawing, these electrodes and conductive paths are disposed to make arms 12 and 14 vibrate in flexure mode, but they could have a different configuration to make the arms vibrate in the same mode or another mode (torsion, shear, etc.). Returning to central arm 18, Figure 1a shows that it carries on its back face two conductive connection pads 28 and 30 located on either side of the centre of gravity G of the resonator lengthways and preferably equidistant from it, these pads 28 and 30 being connected by conductive paths 32 and 34 respectively to conductive paths 24 and 26 which connect the electrodes of each group 20 and 22 to each other. These pads 28 and 30 are electrically connected and fixed to said case. For that purpose and in order to guarantee an accurate positioning as well as a robust fixing of resonator 10 inside its packaging, at least one connection pads 28, 30, but preferably both, comprises an opening through central arm 18 for accurately positioning resonator 10 into its packaging. According to this first embodiment, openings are positioning holes 54 and 56 which have been cut through central arm 18, as clearly visible on the cut view of Figure 1c, these holes being also used to connect the group of electrodes 20 and 22 of resonator 10 to conductive elements inside the packaging. Since these holes 54 and 56 have been cut through central arm 18, one may accurately positioned resonator 10 inside the packaging by looking to marks designed on the bottom of said packaging. Furthermore, during the assembly of the resonator inside its packaging, holes 54, 56 are filled in with conductive glue that allows on the one hand electrically connecting electrodes 20, 22 to conductive elements inside the packaging and on the other hand solidly fixing resonator 10 inside its packaging.

As visible in Figures 1 a and 1 b, the width of central arm 18 shall be at least slightly more than one and a half that of an arm 12 or 14 of tuning fork shaped part. Likewise, the length of central arm 18 is not necessarily equal to that of arms 12 and 14, as shown by Figures 1a and 1 b. It could be for example shorter. However, it is important, on the one hand, that central arm 18 is substantially equidistant from arms 12 and 14, this distance being able to be equal to that which separates the arms of a conventional tuning fork resonator, and that, on the other hand, this central arm 18 has a much greater mass than that of arms 12 and 14 which have to vibrate.

According to the second embodiment shown in Figure 2, openings are fixing and positioning recesses 58 and 60 which have been cut on both sides of central arm 18 facing both vibrating arms 12, 14 of the resonator. As for the holes of Figure 1, these recesses 58, 60 have been cut through the whole depth of central arm 18 and thus allow accurate positioning in the packaging with respect to marks made on the bottom of it and robust fixing by adding conductive glue so that to fill in said recesses. It will be appreciated that holes 54, 56 as well as recesses 58, 60 may have several shapes, such as square, circle or polygonal ones. Recesses 58 and 60 further have the advantage of being manufactured more easily than holes.

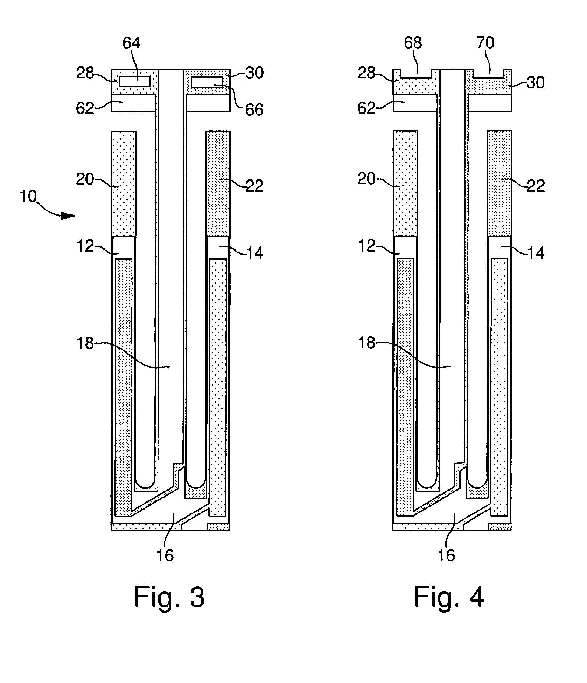

According to the third embodiment shown in Figure 3, the resonator differs from the first two embodiments in that central arm 18 has a narrowed width so that it is about the same to that of one vibrating arm. Though such a thin central arm 18 reduces the width of the overall resonator structure and may be packaged in a thinner packaging (not shown), it may not be used any longer as fixing part for resonator 10. Therefore, a base part 62 is provided at the end of the central arm opposite to linking part 16 and extends beyond vibrating arms 12 and 14. This base part 62 is used both for fixing resonator 10 inside its packaging and for electrically connecting electrodes 20 and 22 of the resonator to conductive elements inside the packaging. In order to guarantee an accurate positioning and safe fixing, holes 64, respectively 66 have been cut through connecting elements 28, respectively 30 carried by base part 62. Thus, when assembling one may see through holes 64 and 66 marks provided on the bottom of the packaging for accurately positioning resonator 10 in its packaging. Further, filling in holes 64 and 66 with glue guarantees a solid fixing of the resonator inside its packaging.

According to the fourth embodiment shown in Figure 4, the resonator differs from the third one in that openings are recesses 68 and 70 which have been cut through connecting elements 28 and 30 on the opposite side of base part 62 with respect to central arm 18 to which it is attached. Recesses 68 and 70 have the advantage of being manufactured more easily than holes. Use of conductive glue for fixing base part 62 to the packaging allows connecting electrodes 20 and 22 to conductive elements inside the packaging.

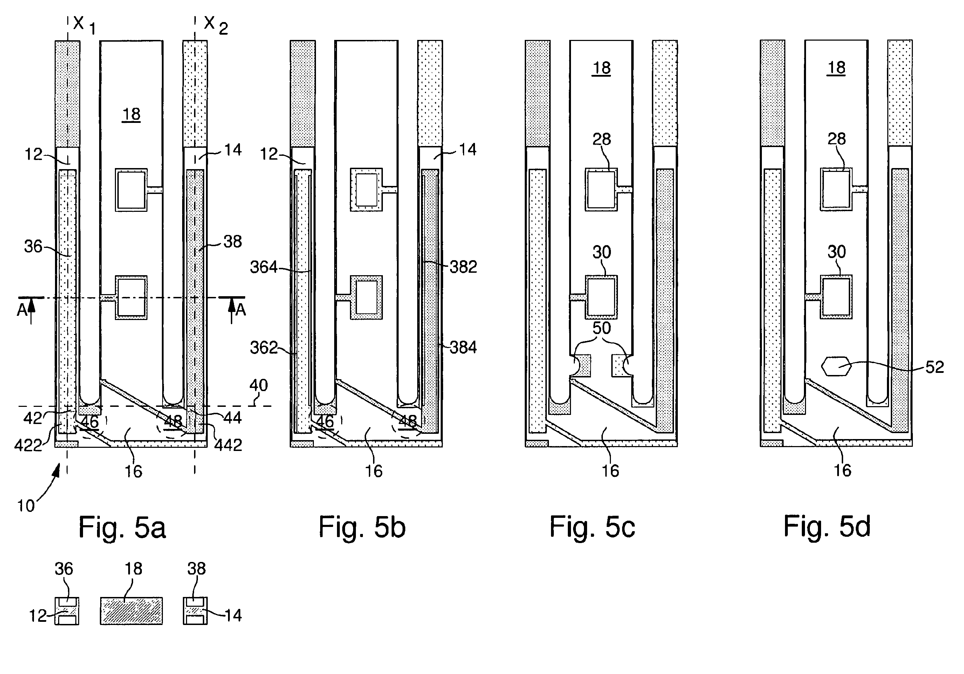

Figures 5a, 5b, 5c and 5d are bottoms views of four variants of the first embodiment of the piezoelectric resonator according to the invention. Figure 5a shows a first variant which differs from the first embodiment in that at least one groove 36, 38 is formed on at least one of a front side and a rear side of each vibrating arm 12, 14, respectively 12, 14, in order to reduce consumption of energy by producing an excitation electrical field which is more homogeneous and locally more intense and for which vibration loss at the arms is low even when the size of the vibrating piece is miniaturized. As shown on the cut view of Figure 5a, each vibrating arm 12, 14 is preferably H-shaped, meaning that one groove 36a, 36b, respectively 38a, 38b is preferably provided on each the front and the rear side of each vibrating arm 12 respectively 14. It will be appreciated that depth of these grooves is preferably between 30% and 50% of the thickness of the corresponding vibrating arm in the depth direction (along axis D) and advantageously between 40% and 50%. It is to be noted that this ratio may be applicable to all forthcoming embodiments with grooves. Use of such grooves on the vibrating arms furnishes precise performances even when the device is miniaturized. Nevertheless, as an alternative only one groove may be provided either on the front or the rear side of each vibrating arm.

Advantageously, in order to further increase the vibrating coupling effect of the vibrating arms, grooves 36, 38 extend in linking part 16. Portions 42, 44 of grooves 36, 38 extending in linking part 16, virtually delimited by dotted line 40, where mechanical stresses are maximums, allow retrieving the electrical field in this high stressed area.

Advantageously, in order to guarantee a better mechanical resistance of the resonator in the high stressed area, groove portions 42, 44 within the linking part 16 are designed with non symmetric shapes with respect to the longitudinal axis (X₁,X₂) of vibrating arms 12, 14. For instance, grooves 36, 38 are designed with a portion 422, 442 of narrowed width within linking part 16. Hollowed out portion 422, 442 of narrowed width of groove 36, 38 is located on the outside with respect to central arm 18. Thus, the quantity of material in the high mechanical stressed areas, which are illustrated by hatched zones 46 and 48 and mainly located in the linking part regions contiguous to vibrating arms 12, 14, is more important and therefore renders these areas more robust to mechanical constraints.

Figure 5b shows a second variant which differs from the first variant above described in that two grooves 362, 364, 382 and 384 are arranged on each the front and the rear sides of each vibrating arm 12, 14. Grooves 362, 364, 382 and 384 advantageously extend within linking part 16 in order to maximize homogeneity of the electrical field. Preferably in order to guarantee a better mechanical resistance of the resonator in the high stressed areas, exterior grooves 364, respectively 382 which are located on the inside with respect to central arm 18 extend shorter within linking part 16 than interior grooves 362, respectively 384 which are located on the outside with respect to central arm 18. Thus, the quantity of material in the high mechanical stressed areas, which are illustrated by hatched zones 46 and 48 and mainly located in the linking part regions contiguous to vibrating arms 12 and 14, is more important and therefore renders these areas more robust to mechanical constraints.

Figures 5c and 5d show third and fourth variants which differ from the first embodiment in that decoupling means 50, respectively 52 may be arranged on central arm 18 near linking part 16 in order to mechanically decouple central arm 18 used to fix resonator 10 in its package (not shown) from vibrating arms 12 and 14. These decoupling means 50, respectively 52 have to be arranged between fixing elements of central arm 18, which are preferably conductive pads 28 and 30, and linking part 16 to which is attached vibrating arms 12 and 14. In the variant shown in Figure 5b, the decoupling means are implemented in the form of notches 50 provided on both sides of central arm 18. These notches 50 may be rectangular-shaped, half-circle-shaped or V-shaped. In the variant shown in Figure 2c, the decoupling means are implemented in the form of a hole 52 cut trough central arm 18. This hole may have different shapes such a rectangular, circle, or hexagonal shape. As for notches, the hole has to be hollowed out between fixing elements 28 and 30 and linking part 16. It will be appreciated that both decoupling means can be implemented together as well.

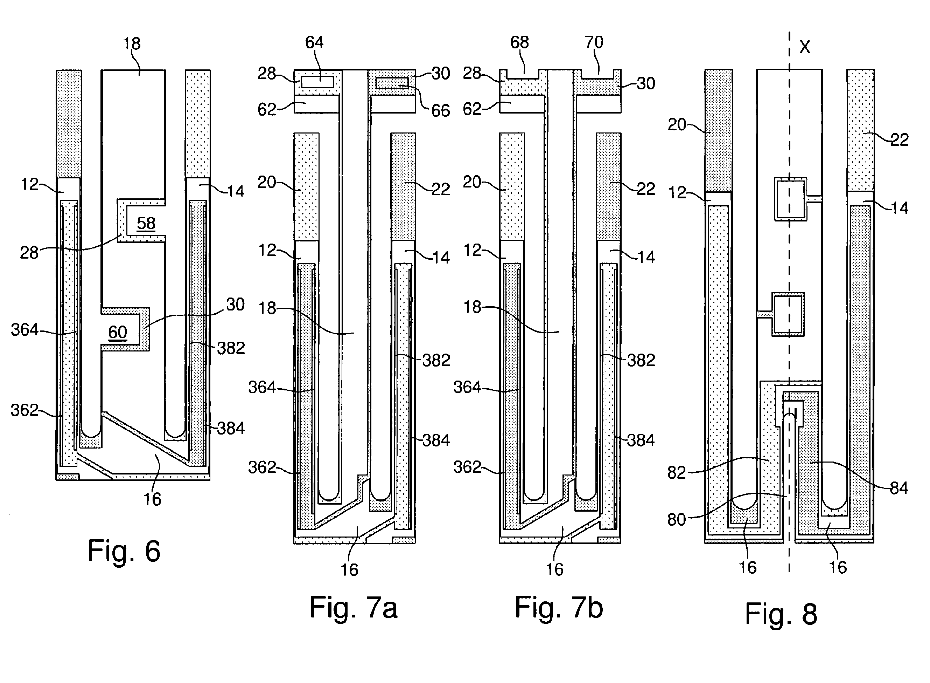

Figure 6 shows a first variant of the second embodiment of Figure 2. This first variant differs from the second embodiment in that two grooves 362, 364, 382 and 384 are arranged on each the front and the rear sides of each vibrating arm 12, 14. Grooves 362, 364, 382 and 384 advantageously extend within linking part 16 in order to maximize homogeneity of the electrical field. Preferably in order to guarantee a better mechanical resistance of the resonator in the high stressed areas, exterior grooves 364, respectively 382 which are located on the inside with respect to central arm 18 extend shorter within linking part 16 than interior grooves 362, respectively 384 which are located on the outside with respect to central arm 18. Thus, the quantity of material in the high mechanical stressed areas, which are illustrated by hatched zones 46 and 48 and mainly located in the linking part regions contiguous to vibrating arms 12 and 14, is more important and therefore renders these areas more robust to mechanical constraints.

It will be appreciated that the three variants shown in relation with Figure 5a, 5c and 5d are also applicable to the second embodiment in which recesses 58 and 60 are used instead of holes 54 and 56 used in the first embodiment.

Figure 7a, respectively 7b, shows a variant of the third embodiment of Figure 3, respectively the fourth embodiment of Figure 4, which differs in that two grooves 362, 364, 382 and 384 are arranged on each the front and the rear sides of each vibrating arm 12, 14. Grooves 362, 364, 382 and 384 advantageously extend within linking part 16 in order to maximize homogeneity of the electrical field. It will be also appreciated that other variants similar to those described in relation with Figures 5a, 5c and 5d may be implemented as well with respect to the third and fourth embodiments.

According to another variant of the first embodiment shown in Figure 8, the resonator differs from the one shown in Figure 1a in that a slot 80 is provided within linking part 16 on the opposite side to the one on which central arm 18 is protruding from and preferably along the longitudinal axis X of the resonator. This slot 80 has for effect to virtually lengthen vibrating arms 12, 14 to the corresponding half of linking part 16. For further optimizing the vibrating coupling effect of the vibrating arms by retrieving the electrical field in all high stressed areas of the cut linking part, in addition to group of electrodes 20, 22, additional electrodes 82, 84 are arranged along slot 80. Advantageously grooves have been hollowed out under electrodes 82, 84 to produce an excitation electrical field which is more homogeneous and locally more intense. Thus, for a determined frequency, use of these electrodes 82, 84, preferably grooved, allows the overall length of the resonator to be reduced. It will be appreciated that this variant may also be applicable to any of the other embodiments.

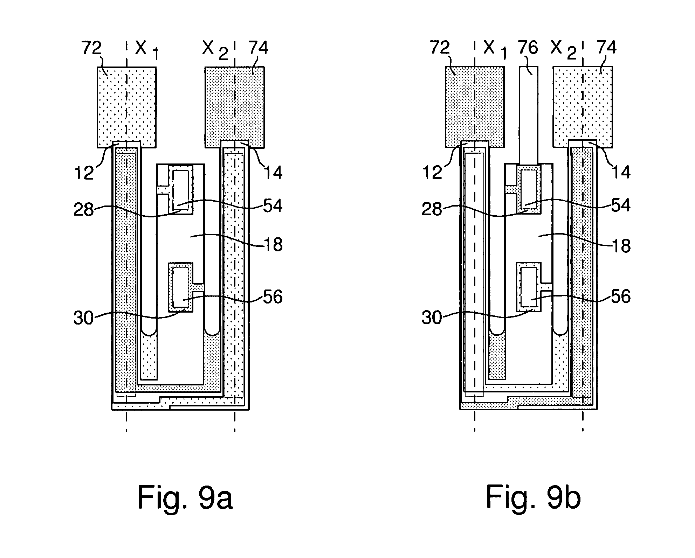

In two other variant shown in Figures 9a and 9b, the resonator differs from the one of the first embodiment in that, on the one hand, the length of central arm 18 is less than that of vibrating arms 12 and 14 and, on the other hand, each vibrating arm 12, respectively 14, ends in a flipper 72, respectively 74, which extends beyond central arm 18. Preferably, these flippers 72 and 74 have a symmetrical rectangular shape with respect to the longitudinal axis (X₁, X₂) of corresponding vibrating arm 12, 14, the flipper width being approximately twice as that of vibrating arm. But in counterpart, it will appreciated that the flipper length can be deduced from the overall length of the vibrating arm without modifying the resonator properties and therefore the resonator length may be reduced accordingly. According to a second variant shown in Figure 9b, a balancing reed 76 has been attached to the central arm end opposite to linking part 16. This balancing reed 76 is located between both flippers 72, 74 of vibrating arms 12, 14 and has a thinner width than that of central arm 18 to let both vibrating arms 12, 14 vibrate without any risk of collisions with them. Moreover reed 76 does not extend beyond flippers 72, 74 along the longitudinal axis of the resonator structure in order to keep the whole resonator length as short as possible. With such a reed 76, better stabilization of the resonator structure is obtained when vibrating and thus fewer mechanical stresses are constrained on fixing parts 28, 30. It will be also appreciated that, these two variants have been represented with holes 54 and 56, but could be as well operating with recesses as shown in relation with the second embodiment.

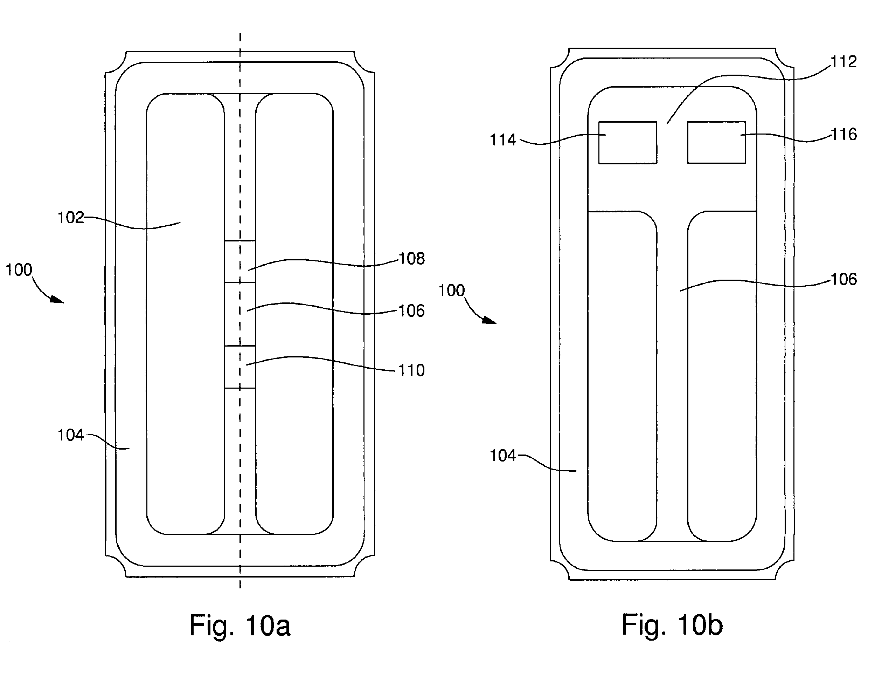

Figure 10a is a top view of a suitable package without its cover for receiving a piezoelectric resonator according to the first or second embodiment of the invention. Case 100 of parallelepiped shape includes a main part formed by a flat bottom 102 and four sides 104 and a cover with an edge (not shown) via which the cover is vacuum soldered, on sides 104 of the main part, by heating and pressure, by means of a soldering frame (also not shown), after the resonator has been mounted in case 100. Additionally, a central rib 106 has been arranged on bottom 102 of case 100, which rib 106 extends along the longitudinal axis X in order to support fixing parts of the resonator. The rib width is chosen so that vibrating arms of the resonator may vibrate freely inside case 100. On rib 106 two conductive elements, such as thin conductive layers, studs or bumps 108 and 110, are arranged for contacting the corresponding conductive pads of the resonator. It will be appreciated that rib 106 shall not extend from one side 104 to the opposite one. Furthermore, it will be also appreciated that conductive elements 108 and 110 which are visible through openings cut in the central arm of the resonator (not shown), may be used as marking for accurately positioning of the resonator when mounting the latter inside case 100.

Figure 10b is a top view of a suitable package without its cover for receiving a piezoelectric resonator according to the third or fourth embodiment of the invention. It differs from the package above described in relation with Figure 10a in that the width of rib 106 is adapted in function of the width of the central arm of the resonator to be mounted in case 100. However, it will be appreciated that this rib 106 is no longer needed since the resonator is attached in case 100 by its base part. Further case 100 comprises a support 112 for said base part of the resonator, these support comprising two conductive elements 114, 116 intended to electrically connect corresponding conductive pads of the resonator.

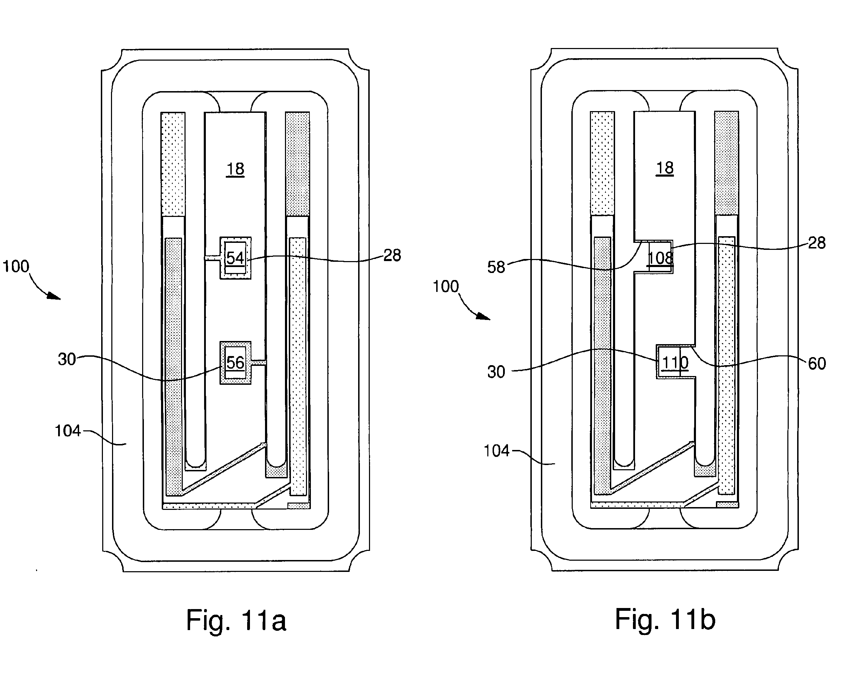

Figures 11a and 11b are different opened top views of a piezoelectric resonator 10 according respectively to the first and second embodiments mounted in a suitable package 100. Figure 11a shows a top view with a resonator according to the first embodiment in which central arm 18 supports conductive pads 28 and 30 to be connected to the corresponding conductive elements arranged on rib 106. The mounting of the resonator is achieved by soldering or gluing with a conductive adhesive its connection pads 28 and 30 onto respective thin layers, studs or bumps. In order to guarantee an accurate positioning of the resonator when mounting it inside its packaging 100, conductive elements 108 and 110 may be seen through holes 54, 56 or recesses 58, 60 (Figure 11b) cut through central arm 18.

In any case, the fact of fixing the resonator to the bottom of the case, in the zone of its centre of gravity, makes the assembly thereof easier and minimises the risk of it tipping during such assembly. For the same reason the shock resistance of the encased resonator is much higher.

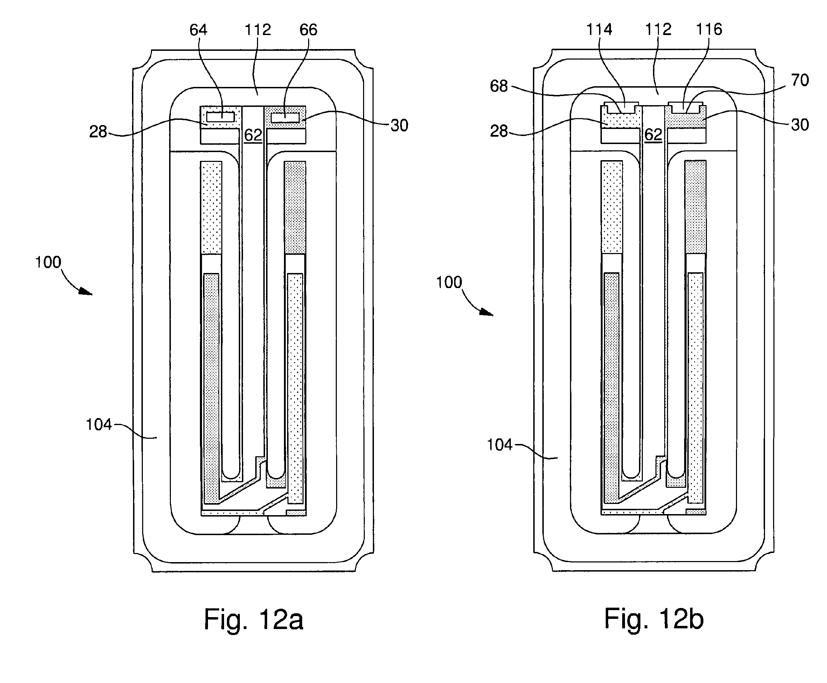

Figures 12a and 12b are different opened top views of a piezoelectric resonator 10 according respectively to the third and fourth embodiments mounted in a suitable package 100. Figure 12a shows a top view with a resonator according to the third embodiment in which base part 62 supports conductive pads 28 and 30 to be connected to corresponding conductive elements 114 and 116 arranged on support element 112. The mounting of the resonator is achieved by soldering or gluing with a conductive adhesive its connection pads 28 and 30 onto respective thin layers, studs or bumps. In order to guarantee an accurate positioning of the resonator when mounting it inside its packaging 100, conductive elements 114 and 116 may be seen through holes 64, 66 or recesses 68, 70 (Figure 12b) cut through base part 62.

It will be appreciated that preferably for further improving the shock resistance of the resonators according to any of the above presented embodiments, the cut out portions where vibrating arms are linked to the linking part are advantageously chosen to minimize visualisation of the crystalline planes of the resonator. In the example of a quartz resonator, the cut out portions form angles of approximately 60° or 120°.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims.

## Claims

1. A piezoelectric resonator (10) intended to be mounted in a case (100) and including a tuning fork shaped part with two parallel vibrating arms (12, 14) connected to each other by a linking part (16), from which protrudes a central arm (18) located between both vibrating arms, said vibrating arms carrying electrodes (20, 22) to make them vibrate, these electrodes being connected to connection elements (28, 30) carried by said central arm, said connection elements being electrically connected and fixed to said case, **characterized in that** at least one connection element comprises an opening (54, 56; 58, 60) through said central arm for positioning said resonator into said case, said opening being filled with conductive glue, said glue allowing to connect one of said electrodes to a conductive element of said case and solidly fixing said resonator to said case.

2. The resonator according to claim 1, **characterized in that** said opening is a hole (54, 56) which has been cut through said central arm.

3. The resonator according to claim 1, **characterized in that** said opening is a recess (58, 60) which has cut on one side of said central arm facing one of said vibrating arms.

4. The resonator according to any of claims 1 to 3, **characterized in that** it comprises two connection elements located on either side of the centre of gravity G of the resonator lengthways and preferably equidistant from it and **in that** each connection element comprise an opening through said central arm.

5. The resonator according to any of claims 1 to 4, **characterized in that** at least one groove (36, 38) is formed on each of the front side and the rear side of each vibrating arm.

6. The resonator according to claim 5, **characterized in that** a portion (42, 44) of each groove of said vibrating arms extends in said linking part.

7. The resonator according to claim 6, **characterized in that** said portion within said linking part has a part (422, 442) with a narrowed width compared to that of the groove, and **in that** said part is located on the outside with respect to said central arm.

8. The resonator according to any of claims 1 to 4, **characterized in that** two grooves (362, 364, 382, 384) are formed on each of the front side and the rear side of each vibrating arm.

9. The resonator according to claim 8, **characterized in that** said grooves of each vibrating arm extends in said linking part.

10. The resonator according to claim 9, **characterized in that** exterior grooves (362, 384) which are located on the outside with respect to said central arm, extend farther within the linking part than interior grooves (364, 382) which are located on the inside with respect to said central arm.

11. The resonator according to any of claims 1 to 10, **characterized in that** the width of said central arm is greater or equal to one and a half the width of said vibrating arms and **in that** said central arm does not extend beyond said vibrating arms.

12. The resonator according to any of claims 1 to 10, **characterized in that** the length of said central arm is less than that of the vibrating arms and **in that** said vibrating arms end in flippers (72, 74) extending beyond said central arm, said flipper width being larger than that of said vibrating arms.

13. The resonator according to claim 12, **characterized in that** a balancing reed (76) attached to said central arm extends between both flippers, width of said balancing reed being smaller than that of said central arm.

14. The resonator according to any of preceding claims, **characterized in that** a decoupling hole (52) has been cut through said central arm between said opening and said linking part.

15. The resonator according to any of claims 1 to 13, **characterized in that** decoupling notches (50) have been cut through between said opening and said linking part on both sides of said central arm facing said vibrating arms.

16. The resonator according to any of preceding claims, **characterized in that** a notch is cut through in said linking part opposite to said central arm.

17. The resonator according to any of claims 1 to 13, **characterized in that** a slot (80) has been arranged within said linking part opposite to said central arm and **in that** additional electrodes (82, 84) have been arranged along said slot.

18. The resonator according to claim 17, **characterized in that** grooves have been hollowed out under said additional electrodes.

19. A piezoelectric resonator (10) intended to be mounted in a case (100) and including a tuning fork shaped with two parallel vibrating arms (12, 14) connected to each other by a linking part (16), from which protrudes a central arm (18) located between both vibrating arms, the width of said central arm being about the same as that of said vibrating arms, said vibrating arms carrying electrodes (20, 22) to make them vibrate, a base part (62) protruding from said central arm opposite to said linking part, said electrodes being connected to connection elements (28, 30) carried by said base part, electrically connected and fixed to said case, **characterized in that** at least one connection element comprises an opening (64, 66; 68, 70) through said base part for positioning said resonator into said case, said opening being filled with conductive glue, said glue allowing to connect one of said electrodes to a conductive element of said case and solidly fixing said resonator to said case.

20. The resonator according to claim 19, **characterized in that** said connection element is a hole (64, 66) which has been cut through said base part.

21. The resonator according to claim 19, **characterized in that** said connection element is a recess (68, 70) which has been cut through one side of said base part opposite to the one facing said central arm.

22. The resonator according to any of claims 19 to 21, **characterized in that** at least one groove is formed on each of the front side and the rear side of each vibrating arm.

23. The resonator according to any of claims 5 to 10, 18 and 22, **characterized in that** depth of said grooves is between 30% and 50%, and preferably between 40% and 50%, of the thickness of said vibrating arms in the depth direction.

## Patentansprüche

1. Piezoelektrischer Resonator (10), der dazu vorgesehen ist, in einem Gehäuse (100) montiert zu werden, und ein Teil in Form einer Abstimmgabel mit zwei parallelen Schwingarmen (12, 14) umfasst, die miteinander durch ein Verbindungsteil (16) verbunden sind, von dem ein Mittelarm (18) vorsteht, der sich zwischen beiden Schwingarmen befindet, wobei die Schwingarme Elektroden (20, 22) tragen, die sie in Schwingungen versetzen, wobei diese Elektroden mit Verbindungselementen (28, 30) verbunden sind, die durch den Mittelarm getragen werden, wobei die Verbindungselemente mit dem Gehäuse elektrisch verbunden und daran befestigt sind, **dadurch gekennzeichnet, dass** wenigstens ein Verbindungselement eine Öffnung (54, 56; 58, 60) durch den Mittelarm umfasst, um den Resonator in dem Gehäuse zu positionieren, wobei die Öffnung mit leitendem Klebstoff gefüllt ist, wobei der Klebstoff ermöglicht, eine der Elektroden mit einem leitenden Element des Gehäuses zu verbinden und den Resonator an dem Gehäuse fest anzubringen.

2. Resonator nach Anspruch 1, **dadurch gekennzeichnet, dass** die Öffnung ein Loch (54, 56) ist, das durch den Mittelarm geschnitten worden ist.

3. Resonator nach Anspruch 1, **dadurch gekennzeichnet, dass** die Öffnung eine Aussparung (58, 60) ist, die auf einer Seite des Mittelarms, die einem der Schwingarme zugewandt ist, ausgeschnitten worden ist.

4. Resonator nach einem der Ansprüche 1 bis 3, **dadurch gekennzeichnet, dass** er zwei Verbindungselemente umfasst, die sich in Längsrichtung beiderseits des Schwerpunkts G des Resonators befinden und vorzugsweise hiervon gleichmäßig beabstandet sind, und dass jedes Verbindungselement eine Öffnung durch den Mittelarm aufweist.

5. Resonator nach einem der Ansprüche 1 bis 4, **dadurch gekennzeichnet, dass** sowohl auf der Vorderseite als auch auf der Rückseite jedes Schwingarms wenigstens eine Nut (36, 38) ausgebildet ist.

6. Resonator nach Anspruch 5, **dadurch gekennzeichnet, dass** sich ein Abschnitt (42, 44) jeder Nut der Schwingarme in das Verbindungsteil erstreckt.

7. Resonator nach Anspruch 6, **dadurch gekennzeichnet, dass** der Abschnitt in dem Verbindungsteil einen Teil (422, 442) mit verringerter Breite im Vergleich zu jener der Nut besitzt, und dass sich der Teil auf der Außenseite in Bezug auf den Mittelarm befindet.

8. Resonator nach einem der Ansprüche 1 bis 4, **dadurch gekennzeichnet, dass** sowohl auf der Vorderseite als auch auf der Rückseite jedes Schwingarms zwei Nuten (362, 364, 382, 384) ausgebildet sind.

9. Resonator nach Anspruch 8, **dadurch gekennzeichnet, dass** sich die Nuten jedes Schwingarms in das Verbindungsteil erstrecken.

10. Resonator nach Anspruch 9, **dadurch gekennzeichnet, dass** sich die äußeren Nuten (362, 384), die sich an der Außenseite in Bezug auf den Mittelarm befinden, weiter innerhalb des Verbindungsteils als die inneren Nuten (364, 382) erstrecken, die sich an der Innenseite in Bezug auf den Mittelarm befinden.

11. Resonator nach einem der Ansprüche 1 bis 10, **dadurch gekennzeichnet, dass** die Breite des Mittelarms größer oder gleich der eineinhalbfachen Breite der Schwingarme ist, und dass sich der Mittelarm nicht über die Schwingarme hinaus erstreckt.

12. Resonator nach einem der Ansprüche 1 bis 10, **dadurch gekennzeichnet, dass** die Länge des Mittelarms kleiner als jene der Schwingarme ist und dass die Schwingarme in Fahnen (72, 74) enden, die sich über den Mittelarm hinaus erstrecken, wobei die Breite der Fahnen größer als jene der Schwingarme ist.

13. Resonator nach Anspruch 12, **dadurch gekennzeichnet, dass** sich zwischen den beiden Fahnen eine Ausgleichszunge (76) erstreckt, die an dem Mittelarm befestigt ist, wobei die Breite der Ausgleichszunge kleiner als jene des Mittelarms ist.

14. Resonator nach einem der vorhergehenden Ansprüche, **dadurch gekennzeichnet, dass** durch den Mittelarm zwischen der Öffnung und dem Verbindungsteil ein Entkopplungsloch (52) geschnitten worden ist.

15. Resonator nach einem der Ansprüche 1 bis 13, **dadurch gekennzeichnet, dass** zwischen der Öffnung und dem Verbindungsteil auf beiden Seiten des Mittelarms, die den Schwingarmen zugewandt sind, Entkopplungsnuten (50) geschnitten worden sind.

16. Resonator nach einem der vorhergehenden Ansprüche, **dadurch gekennzeichnet, dass** in das Verbindungsteil gegenüber dem Mittelarm eine Nut geschnitten worden ist.

17. Resonator nach einem der Ansprüche 1 bis 13, **dadurch gekennzeichnet, dass** in dem Verbindungsteil gegenüber dem Mittelarm ein Schlitz (80) angeordnet worden ist, und dass zusätzliche Elektroden (82, 84) längs des Schlitzes angeordnet worden sind.

18. Resonator nach Anspruch 17, **dadurch gekennzeichnet, dass** unter den zusätzlichen Elektroden Nuten ausgehöhlt worden sind.

19. Piezoelektrischer Resonator (10), der dazu vorgesehen ist, in einem Gehäuse (100) montiert zu werden, und ein Teil in Form einer Abstimmgabel mit zwei parallelen Schwingarmen (12, 14) umfasst, die miteinander durch ein Verbindungsteil (16) verbunden sind, von dem ein Mittelarm (18) vorsteht, der sich zwischen den beiden Schwingarmen befindet, wobei die Breite des Mittelarms etwa gleich jener der Schwingarme ist, wobei die Schwingarme Elektroden (20, 22) tragen, um sie zu Schwingungen zu veranlassen, wobei gegenüber dem Verbindungsteil ein Basisteil (62) von dem Mittelarm vorsteht, wobei die Elektroden mit Verbindungselementen (28, 30) verbunden sind, die von dem Basisteil getragen werden und mit dem Gehäuse elektrisch verbunden und daran befestigt sind, **dadurch gekennzeichnet, dass** wenigstens ein Verbindungselement eine Öffnung (64, 66; 68, 70) durch das Basisteil umfasst, um den Resonator in dem Gehäuse anzuordnen, wobei die Öffnung mit einem leitenden Klebstoff gefüllt ist, wobei der Klebstoff ermöglicht, eine der Elektroden mit einem leitenden Element des Gehäuses zu verbinden und den Resonator an dem Gehäuse fest anzubringen.

20. Resonator nach Anspruch 19, **dadurch gekennzeichnet, dass** das Verbindungselement ein Loch (64, 66) ist, das durch das Basisteil geschnitten worden ist.

21. Resonator nach Anspruch 19, **dadurch gekennzeichnet, dass** das Verbindungselement eine Aussparung (68, 70) ist, die in eine Seite des Basisteils gegenüber jener Seite, die dem Mittelarm zugewandt ist, geschnitten worden ist.

22. Resonator nach einem der Ansprüche 19 bis 21, **dadurch gekennzeichnet, dass** wenigstens eine Nut sowohl auf der Vorderseite als auch auf der Rückseite jedes Schwingarms ausgebildet ist.

23. Resonator nach einem der Ansprüche 5 bis 10, 18 und 22,
**dadurch gekennzeichnet, dass** die Tiefe der Nuten im Bereich von 30 % bis 50 % und vorzugsweise im Bereich von 40 % bis 50 % der Dicke der Schwingarme in Tiefenrichtung liegt.

## Revendications

1. Résonateur piézo-électrique (10) prévu pour être monté dans un boîtier (100) et comprenant une structure en forme de diapason avec deux bras vibrants (12, 14) parallèles reliés l'un à l'autre par un élément de liaison (16), à partir duquel s'étend un bras central (18) disposé entre les deux bras vibrants, lesdits bras vibrants portant des électrodes (20, 22) pour les faire vibrer, ces électrodes étant connectées à des éléments de connexion (28, 30) portés par ledit bras central, lesdits éléments de connexion étant électriquement reliés et fixés au dit boîtier, **caractérisé en ce que** au moins un élément de connexion comprend une ouverture (54, 56, 58, 60) traversant ledit bras central pour le positionnement du dit résonateur dans ledit boîtier, ladite ouverture étant remplie de colle conductrice, ladite colle permettant de connecter l'une des dites électrodes à un élément conducteur du dit boîtier et fixant solidement ledit résonateur au dit boîtier.

2. Résonateur selon la revendication 1, **caractérisé en ce que** ladite ouverture et un trou (54, 56) percé dans ledit bras central.

3. Résonateur selon la revendication 1, **caractérisé en ce que** ladite ouverture est une encoche (58, 60) découpée dans un bord du dit bras central vis-à-vis d'un des dits bras vibrants.

4. Résonateur selon l'une des revendications 1, 2 ou 3, **caractérisé en ce qu'**il comprend deux éléments de connexion disposés, dans le sens de la longueur, de part et d'autre du centre de gravité G du résonateur et de préférence à égale distance de ce dernier, et **en ce que** chaque élément de connexion comprend une ouverture à travers ledit bras central.

5. Résonateur selon l'une quelconque des revendications 1 à 4, **caractérisé en ce qu'**au moins une rainure (36, 38) est formée sur la face avant et sur la face arrière de chaque bras vibrant.

6. Résonateur selon la revendication 5, **caractérisé en ce qu'**une partie (42, 44) de chaque rainure s'étend dans l'élément de liaison.

7. Résonateur selon la revendication 6, **caractérisé en ce que** ladite partie dans l'élément de liaison comprend une portion (422, 442) de largeur réduite relativement à celle de la rainure, et **en ce que** ladite portion et disposée à l'extérieur relativement au dit bras central.

8. Résonateur selon l'une quelconque des revendications 1 à 4, **caractérisé en ce que** deux rainures (362, 364, 382, 384) sont formées sur la face avant et sur la face arrière de chaque bras vibrant.

9. Résonateur selon la revendication 8, **caractérisé en ce que** lesdites rainures de chaque bras vibrant s'étendent dans l'élément de liaison.

10. Résonateur selon la revendication 9, **caractérisé en ce que** des rainures extérieures (362, 384) qui sont qui sont disposées à l'extérieur relativement au dit bras central, s'étendent plus loin dans l'élément de liaison que des rainures intérieures (364, 382) qui sont disposées à l'intérieur relativement au dit bras central.

11. Résonateur selon l'une quelconque des revendications 1 à 10, **caractérisé en ce que** la largeur du dit bras central est plus grande ou égale à une fois et demi la largeur des dits bras vibrants et **en ce que** ledit bras central ne s'étend pas au-delà des dits bras vibrants.

12. Résonateur selon l'une quelconque des revendications 1 à 10, **caractérisé en ce que** la longueur du dit bras central et inférieure à celle des bras vibrants et **en ce que** lesdits bras vibrants se terminent par des palmes (72, 74) qui s'étendent au-delà du dit bras central, la largeur des dites palmes étant plus grande que celle des dits bras vibrants.

13. Résonateur selon la revendication 12, **caractérisé en ce qu'**une baguette d'équilibrage (76) reliée au dit bras central s'étend entre les deux palmes, la largeur de ladite baguette d'équilibrage étant plus petite que celle du dit bras central.

14. Résonateur selon l'une quelconque des revendications précédentes, **caractérisé en ce qu'**un trou de découplage (52) a été percé dans ledit bras central entre ladite ouverture et ledit élément de liaison.

15. Résonateur selon l'une quelconque des revendications 1 à 13, **caractérisé en ce que** des encoches de découplage (50) ont été découpées entre ladite ouverture et ledit élément de liaison de part et d'autre du dit bras central vis-à-vis des dits bras vibrants.

16. Résonateur selon l'une quelconque des revendications précédentes, **caractérisé en ce qu'**une encoche est découpée dans ledit élément de liaison à l'opposé du dit bras central.

17. Résonateur selon l'une quelconque des revendications 1 à 13, **caractérisé en ce qu'**une fente (80) à été formée dans ledit élément de liaison à l'opposé du dit bras central et **en ce que** des électrodes additionnelles (82, 84) ont été disposées le long de ladite fente.

18. Résonateur selon la revendication 17, **caractérisé en ce que** des rainures ont été creusées sous lesdites électrodes additionnelles.

19. Résonateur piézo-électrique (10) prévu pour être monté dans un boîtier (100) et comprenant un diapason formé avec deux bras vibrants (12, 14) parallèles reliés l'un à l'autre par un élément de liaison (16), à partir duquel s'étend un bras central (18) disposé entre les deux bras vibrants, la largeur du dit bras central étant environ égale à celle des dits bras vibrants, lesdits bras vibrants portant des électrodes (20, 22) pour les faire vibrer, un élément de base (62) s'étendant à partir du dit bras central à l'opposé du dit élément de liaison, lesdites électrodes étant connectées à des éléments de connexion (28, 30) portés par ledit élément de base, électriquement reliés et fixés au dit boîtier, **caractérisé en ce que** au moins un élément de connexion comprend une ouverture (64, 66, 68, 70) traversant ledit élément de base pour le positionnement du dit résonateur dans ledit boîtier, ladite ouverture étant remplie de colle conductrice, ladite colle permettant de connecter l'une des dites électrodes à un élément conducteur du dit boîtier et fixant solidement ledit résonateur au dit boîtier.

20. Résonateur selon la revendication 19, **caractérisé en ce que** ledit élément de connexion est un trou (64, 66) percé dans ledit élément de base.

21. Résonateur selon la revendication 19, **caractérisé en ce que** ledit élément de connexion est une encoche (68, 70) découpée dans un bord du dit élément de base à l'opposé de celui qui est en regard du dit bras central.

22. Résonateur selon l'une des revendications 19, 20 ou 21, **caractérisé en ce qu'**au moins une rainure est formée sur la face avant et sur la face arrière de chaque bras vibrant.

23. Résonateur selon l'une quelconque des revendications 5 à 10, 18 et 22, **caractérisé en ce que** la profondeur des dites rainures correspond à entre 30% et 50%, préférablement à entre 40% et 50%, de l'épaisseur des dits bras vibrants dans le sens de la profondeur.
